# EUROPEAN PATENT APPLICATION

(11) **EP 4 745 604 A1**
(43) Date of publication of application: **20.05.2026**
(21) Application number: 24856640.8
(22) Date of filing: 01.07.2024
(51) Int. Cl.: G01R 31/396, G01R 31/367, G01R 31/36, G06F 16/906

(54) **DATA ANALYSIS DEVICE AND OPERATING METHOD THEREOF**

(30) Priority: 22.08.2023 KR 20230110181
(71) Applicant: LG Energy Solution, Ltd., Seoul 07335 (KR)
(72) Inventor: HEO, Jung Eun, Daejeon 34122 (KR)
(74) Representative: Plasseraud IP
(86) International application number: PCT/KR2024/009236
(87) International publication number: WO 2025/042026

(57) **Abstract**

According to an embodiment disclosed in this document, a data analysis apparatus may include an information acquisition unit configured to acquire a plurality of datasets, and a controller configured to generate feature data representing the correlation between at least two factors for analyzing the type of each battery dataset, extract target data associated with at least one parameter based on the characteristic of each feature data, and cluster the feature data based on the target data.

## Description

### TECHNICAL FIELD

### CROSS REFERENCE TO RELATED APPLICATION

This application claims priority to Korean Patent Application No. 10-2023-0110181, filed August 22, 2023, the entire contents of which is incorporated herein for all purposes by this reference.

### TECHNICAL FIELD

The embodiments disclosed in this document relate to a data analysis apparatus and operating method thereof.

### BACKGROUND ART

Recently, research and development on secondary batteries have been actively conducted. Here, the secondary battery is a rechargeable battery and includes all of the conventional Ni/Cd batteries, Ni/MH batteries, and recent lithium ion batteries. Among the secondary batteries, Lithium ion batteries have an advantage of much higher energy density than the conventional Ni/Cd batteries and Ni/MH batteries. In addition, Lithium-ion batteries can be manufactured small and lightweight enough to be used as power sources for mobile devices and recently expand their usage range to power sources for electric vehicles, drawing attention as a next-generation energy storage medium.

Clustering techniques, which group similar data together, are commonly employed to analyze the characteristics of battery data. However, the characteristics of battery data are influenced by various factors, and when clustering is performed in consideration of the correlations of these factors, the high dimensionality of the data and increased computational complexity arise due to the combination of multiple factors. There is therefore a need for a data analysis method capable of improving battery data clustering efficiency and clustering performance.

### DISCLOSURE

### TECHNICAL PROBLEM

It is an object of the embodiments disclosed in this document to provide a data analysis apparatus and operating method thereof capable of improving clustering results while reducing computational complexity in the battery data clustering process.

The technical objects of the embodiments disclosed in this document are not limited to the aforesaid, and other objects not described herein with be clearly understood by those skilled in the art from the descriptions below.

### TECHNICAL SOLUTION

According to an embodiment disclosed in this document, a data analysis apparatus may include an information acquisition unit configured to acquire a plurality of battery datasets, and a controller configured to generate, for each battery dataset, feature data representing the correlation between at least two factors for analyzing the type of battery dataset, extract, for each feature data, target data associated with at least one parameter based on the characteristic of feature data, and cluster the feature data based on the target data.

According to an embodiment, the feature data may include contour image data.

According to an embodiment, the at least one parameter may include at least one of the number of peak points, the width, length, and centroid coordinates of each peak point in the contour image data.

According to an embodiment, the controller may calculate the number of peak points for each feature data and group the feature data based on the number of peak points.

According to an embodiment, the controller may cluster the feature data belonging to each group based on the width, length, and centroid coordinates of the peak point for each feature data.

According to an embodiment, the controller may classify the types of the battery datasets based on the clustering result.

According to an embodiment, the controller generates the feature data based on the joint probability density function (Joint PDF) of the at least two factors.

According to an embodiment disclosed in this document, an operating method of a data analysis apparatus may include acquiring a plurality of battery datasets, generating, for each battery dataset, feature data representing the correlation between at least two factors for analyzing the type of battery dataset, extracting, for each feature data, target data associated with at least one parameter based on the characteristic of feature data, and clustering the feature data based on the target data.

According to an embodiment, the feature data may include contour image data, and the at least one parameter comprises at least one of the number of peak points, the width, length, and centroid coordinates of each peak point in the contour image data.

According to an embodiment, the calculating of the target data may include calculating the number of peak points for each feature data, grouping the feature data based on the number of peak points, and extracting the target data based on the width, length, and centroid coordinates of the peak point for each feature data.

According to an embodiment, the clustering of the feature data based on the target data may include, for each group, clustering the feature data belonging to each group based on the target data.

According to an embodiment, the method may further include classifying the types of the battery datasets based on the clustering result.

### ADVANTAGEOUS EFFECTS

The data analysis apparatus and operating method thereof according to an embodiment disclosed in this document is capable of reducing computational load and complexity by extracting target data with reduced data size.

Additionally, the data analysis apparatus and operating method thereof according to an embodiment disclosed in this document is capable of improving clustering performance by more effectively reflecting the characteristics of the clustering target through target data-based clustering.

In addition, various effects identified directly or indirectly through this document can be provided.

### DESCRIPTION OF DRAWINGS

FIG. 1 is a diagram illustrating the configuration of a data analysis apparatus according to an embodiment disclosed in this document;
FIG. 2 is a diagram illustrating an example of feature data in the form of contour line images according to an embodiment disclosed in this document;
FIGS. 3a and 3b are diagrams illustrating examples of feature data based on the number of peak points according to an embodiment disclosed in this document;
FIG. 4 is a flowchart illustrating an operation method of a data analysis apparatus according to an embodiment disclosed in this document;
FIG. 5 is a flowchart illustrating the process of extracting target data by a data analysis apparatus according to an embodiment disclosed in this document; and
FIG. 6 is a diagram illustrating a hardware configuration of a computing system for performing the operating method of a data analysis apparatus according to an embodiment disclosed in this document.

### MODE FOR INVENTION

Hereinafter, various embodiments of the present invention will be described with reference to the accompanying drawings. However, the description is not intended to limit the present invention to particular embodiments, and it should be construed as including various modifications, equivalents, and/or alternatives of the embodiments described herein.

In this document, the singular noun corresponding to an item may encompass one or more instances of that item, unless explicitly indicated otherwise in context. In this document, phrases such as "A or B", "at least one of A and B", "at least one of A or B", "A, B or C", "at least one of A, B, and C", and "at least one of A, B, or C" may each refer to any of the listed items individually or any combination of those items. Terms such as "the first", "the second", "first", "second" are used simply to distinguish one component from another and do not limit these components in other aspects (e.g., importance or order). In this document, when it is mentioned that a component (e.g., the first component) is "coupled" or "connected" to another component (e.g., the second component) with or without terms like "functionally" or "communicatively," it implies that the first component may be connected to the second component directly (e.g., via wired connection), wirelessly, or through a third component.

Each component described in this document (e.g., modules or programs) may include one or more instances. According to various embodiments, one or more components or operations described herein may be omitted, or one or more other components or operations may be added. Alternatively or additionally, a plurality of components (e.g., modules or programs) may be integrated into a single component. In this case, the integrated component may perform one or more functions of each of the plurality of components identically or similarly to those performed by the corresponding component of the plurality of components prior to the integration. According to various embodiments, operations performed by modules, programs, or other components are executed sequentially, in parallel, iteratively, or heuristically, or one or more of the operations are executed in a different order, omitted, or one or more other operations may be added.

The term "module" or "unit" used in this document may encompass units implemented in hardware, software, or firmware, and may be used interchangeably with terms such as logic, logic block, component, or circuit. A module may be a component assembled as a whole or one or more units performing one or more functions, which may constitute the minimum unit of the component or a part thereof. For example, according to one embodiment, a module may be implemented in the form of an application-specific integrated circuit (ASIC).

Various embodiments of this document may be implemented as software (e.g., a program or application) including one or more instructions stored on a machine-readable storage medium (e.g., memory). For example, the processor of a device may invoke and execute at least one instruction stored on a storage medium. This enables the device to operate to perform at least one function in accordance with the at least one invoked instruction. The one or more instructions may include code generated by a compiler or code executable by an interpreter. The machine-readable storage medium may be provided in the form of a non-transitory storage medium. Here, 'non-transitory' mealy means that the storage medium is a tangible device and does not include signals (e.g., electromagnetic waves), and this term is used regardless of whether the data is stored permanently or temporarily.

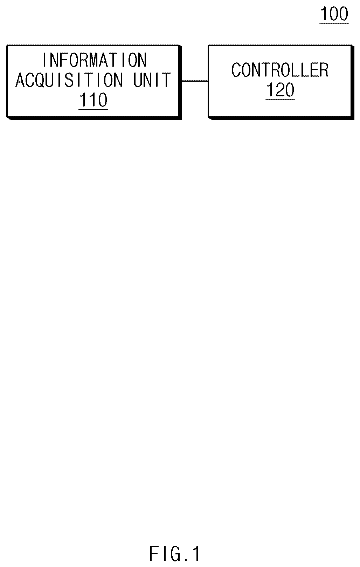

FIG. 1 is a diagram illustrating the configuration of a data analysis apparatus according to an embodiment disclosed in this document.

With reference to FIG. 1, the data analysis apparatus 100 may include an information acquisition unit 110 and a controller 120.

The data analysis apparatus 100 may cluster battery datasets to classify types of battery datasets. The data analysis apparatus 100 may generate feature data from each battery dataset and extract target data with smaller size than the feature data. Through this, the data analysis apparatus 100 may reduce computational complexity in the clustering process and produce clustering results that more distinctly reflect the features.

The information acquisition unit 110 may acquire a plurality of battery datasets. Each battery dataset may include time-series data for battery data. For example, the information acquisition unit 110 may obtain a plurality of battery datasets from batteries installed in various vehicles. As an example, the information acquisition unit 110 may receive battery data from battery management systems (BMS) of battery packs installed in each vehicle, as well as from on-board diagnostics (OBD) devices equipped in vehicles. In an embodiment, the data analysis apparatus 100 may acquire battery datasets from each vehicle and determine individualized types of vehicle drivers by analyzing the type of each battery dataset.

The controller 120 may generate feature data representing the correlation between at least two factors to analyze the type of each battery dataset.

The at least two factors may each be factors for analyzing the type of battery dataset. As an example, each factor may include at least initial state of charge (SOC) at charge start, depth of discharge (DoD) at charge, charging C-rate, starting temperature at charge, maximum temperature at charge, charge start time, charge start day of the week, start time of driving, driving distance, starting temperature of driving, maximum temperature of driving, driving DoD, distribution of driving speeds, discharge time, and discharge end day of the week. Each factor is not limited to these and may include factors without restriction that may affect battery conditions, such as duration of idle state and ambient temperature.

The controller 120 may analyze the correlation between at least two factors. According to an embodiment, the controller 120 may analyze the correlation between at least two factors based on various operations capable of producing correlations between factors in each dataset (e.g., covariance and joint probability). According to an embodiment, the controller 120 may analyze the correlation between at least two factors based on the joint probability density (Joint PDF) of at least two factors.

The controller 120 may generate feature data representing the correlation between at least two factors. For example, the controller 120 may illustrate the feature data in various ways such as graphs, images, and histograms to represent the correlation between at least two factors.

According to an embodiment, the feature data may include contour image data. The controller 120 may generate the feature data by representing the correlation between at least two factors as a contour image. The controller 120 may also represent the feature data not only in contour image format but also in other graph or image formats. In the following description, it is described that the feature data includes contour image data, for convenience of explanation.

According to an embodiment, the controller 120 may generate feature data based on the joint probability density (Joint PDF) of at least two factors. The controller 120 may represent the joint probability density of at least two factors as contour image data. For example, the controller 120 may generate a contour image by connecting points with the same probability density along the same lines.

The controller 120 may also extract target data associated with at least one parameter based on the characteristics of each feature data. The parameters based on the characteristics of feature data may include various parameters that may be extracted or derived from the feature data. For example, in contour image data, at least one parameter may include the number of peak points, the width, length, and coordinates of the center of each peak point. Additionally, various parameters such as the number of contours, degree of spread in distribution, and others may also be included.

In an embodiment, the controller 120 may extract target data from the feature data. The feature data represents correlations between at least two factors, and due to its large size, clustering the feature data increases the amount of computation and complexity. Therefore, the controller 120 may reduce the size of data by extracting target data associated with factors from the feature data. Consequently, the amount of computation and computational complexity can be reduced during the clustering process.

The controller 120 may cluster the feature data based on the target data. When clustering is performed on feature data with a large size, all data in the feature data is reflected in the clustering process, which may lower the discriminative power of the data and degrade the clustering results. Therefore, the controller 120 may conduct clustering on reduced-size target data to effectively reflect the characteristics of each battery dataset and achieve clearer distinction of characteristics within each cluster, thereby enhancing classification results. Accordingly, it can solve the problem of mixed clusters that may occur when clustering with large data due to the lowered discriminative power of the data.

Since target data and feature data have a corresponding relationship, the controller 120 may cluster feature data into a plurality of clusters according to the clustering results of target data such that the feature data corresponds to the clustering results of target data.

According to an embodiment, the controller 120 may calculate the number of peak points for each feature data. The controller 120 may calculate the number of peak points in the contour image of the feature data. Peak points, for example, may refer to the points in a contour image where the data values (such as probability density values) are highest. In another example, peak points may refer to the contours that represent the highest data values.

According to an embodiment, the controller 120 may group feature data based on the number of peak points. The controller 120 may group feature data based on the number of peak points to enhance clustering results by clustering feature data using the same criterion. The controller 120 may group feature data based on the number of peak points because the size of the data of the target data may be different when the number of peak points is different. For example, the controller 120 may group feature data with the same number of peak points into one group.

According to an embodiment, the controller 120 may extract target data based on the width, length, and centroid coordinates of each peak point for each feature data. Here, the width of a peak point may refer to the x-axis width of the peak point in the contour image, the length may refer to the y-axis length of the peak point in the contour image, and the centroid coordinates may refer to the x-axis and y-axis coordinates of the peak's center in the contour image. To perform clustering under uniform criteria, the controller 120 may set the size of contour images uniformly.

In this example, the controller 120 may extract target data with a size of (4 * number of peak points). That is, the controller 120 may extract the width, length, x-coordinate of the center, and y-coordinate of the center for each peak. By extracting target data in this manner, the controller 120 may group feature data based on the number of peak points, which varies the size of the data.

According to an embodiment, the controller 120 may cluster the feature data based on the target data for each group. For example, the controller 120 may classify target data with similar characteristics into the same cluster by analyzing the characteristics of the target data. The characteristics of the target data may include trends and distributions of data values included in the target data. For example, the controller 120 may employ various algorithms such as decision tree-based algorithms like XGBoost, K-nearest neighbor (K-NN) algorithms like K-means, and support vector machine (SVM) algorithms to cluster the target data. In an embodiment, the controller 120 may include a learning model to cluster the feature data based on the target data.

According to an embodiment, the controller 120 may classify the types of battery datasets based on the clustering results. The types of battery datasets may be represented by combinations of characters that can identify patterns of battery usage and driving habits of the users of vehicles equipped with the batteries. For example, the controller 120 may express the types of battery datasets with combinations of multiple characters similar to personality types represented by Myers-Briggs Type Indicator (MBTI), which represents individual personality types using combinations of multiple characters. The controller 120 may represent user types not only with combinations of characters but also with grades expressed by numbers, graphs, symbols, shapes, and various other methods.

By performing clustering based on target data, the controller 120 may derive classification results where the characteristics of each cluster are more distinctly differentiated, thus potentially improving the performance of type classification of battery datasets using enhanced clustering results.

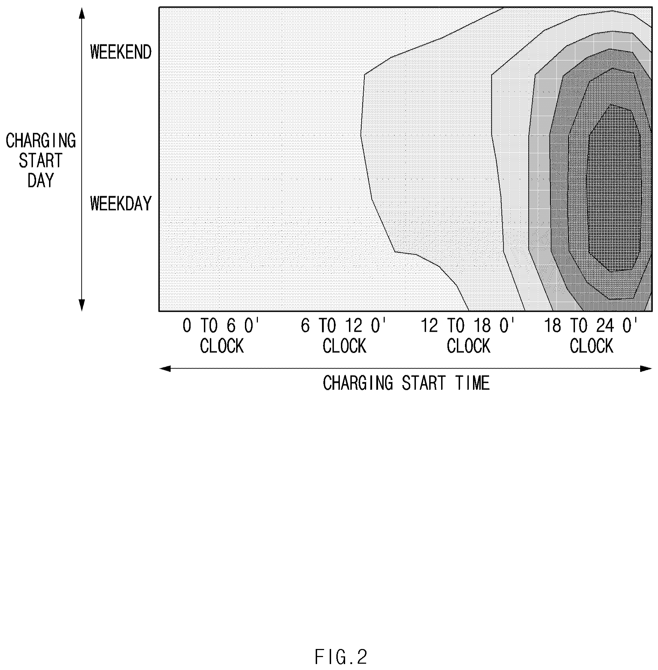

FIG. 2 is a diagram illustrating an example of feature data in the form of contour line images according to an embodiment disclosed in this document.

With reference to FIG. 2, the controller 120 may generate feature data representing the correlation between at least two factors in the form of contour images, where each data value of the feature data may represent the joint probability density of the two factors, and contours connect points with equal probability density values.

In FIG. 2 shows feature data representing the correlation between charging start time and charging start day of the week as an example. Here, charging start time may be expressed in 24 units from 0 to 24 hours, and charging start day of the week may be expressed in 7 units from Monday to Sunday. Consequently, the feature data may have a data size of (24*7).

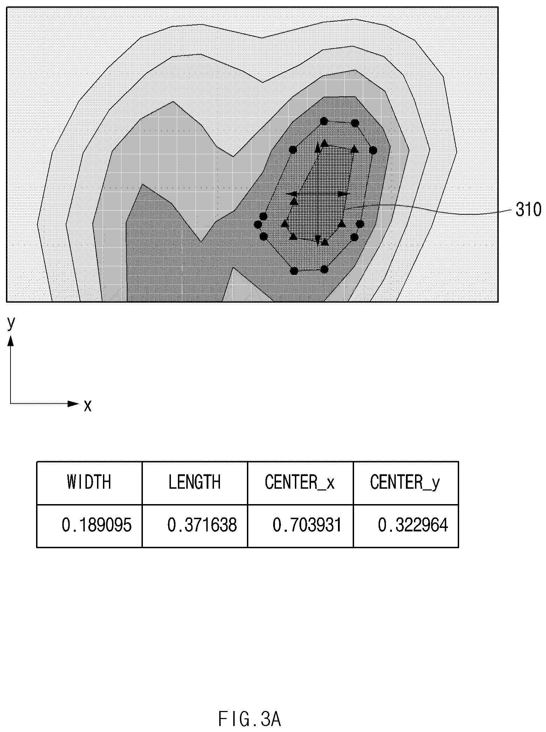

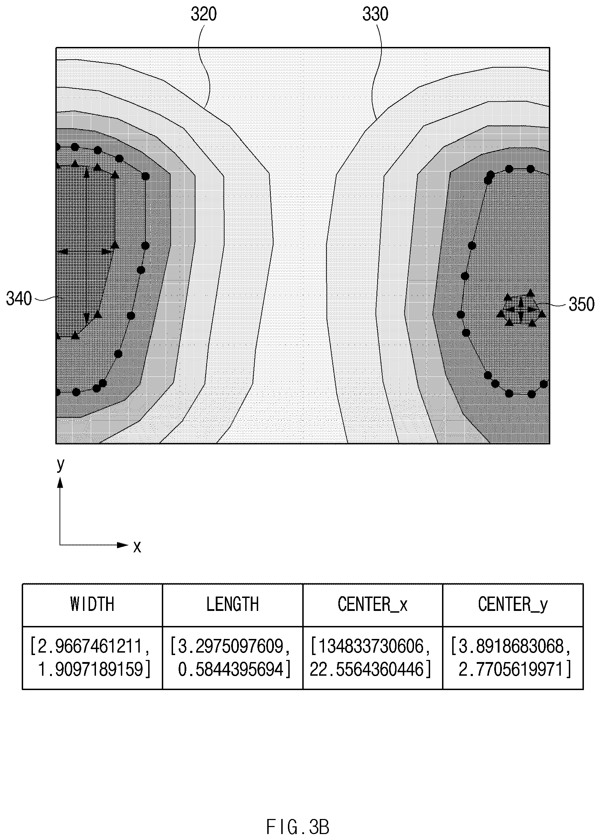

FIGS. 3a and 3b are diagrams illustrating examples of feature data based on the number of peak points according to an embodiment disclosed in this document. FIG. 3a illustrates feature data with one peak point and the corresponding target data. FIG. 3b illustrates feature data with two peak points and the corresponding target data.

The controller 120 may determine the number of peak points for each feature data. A peak point may refer to the highest point in a contour image (e.g., the point with the highest probability density) or the highest contour line. For example, in FIG. 3a, the highest contour line 310 may represent a peak point. Similarly, when there are distinct contour line patterns 320 and 330 in the feature data as shown in FIG. 3b, the controller 120 may identify each highest contour line 340 and 350 in each contour line pattern as peak points.

The controller 120 may group feature data based on the number of peak points. For example, the controller 120 may group the feature data illustrated in FIG. 3a and the feature data illustrated in FIG. 3b into separate groups. That is, since the size of the target data varies depending on the number of peak points, the controller 120 may group feature data based on the number of peak points to allow clustering using consistent criteria.

The controller 120 may extract target data based on the width, length, and centroid coordinates of each peak point for each feature data. For example, the controller 120 may extract target data with the size of the of (4 * the number of peak points) as shown in FIGS. 3a and 3b.

By extracting target data from feature data in this manner, controller 120 may reduce the size of the data to be clustered. For example, with reference to FIGS. 2, 3a, and 3b, it can be observed that the data size is significantly reduced from (24 * 7) to (4 * the number of peak points) as controller 120 extracts the target data.

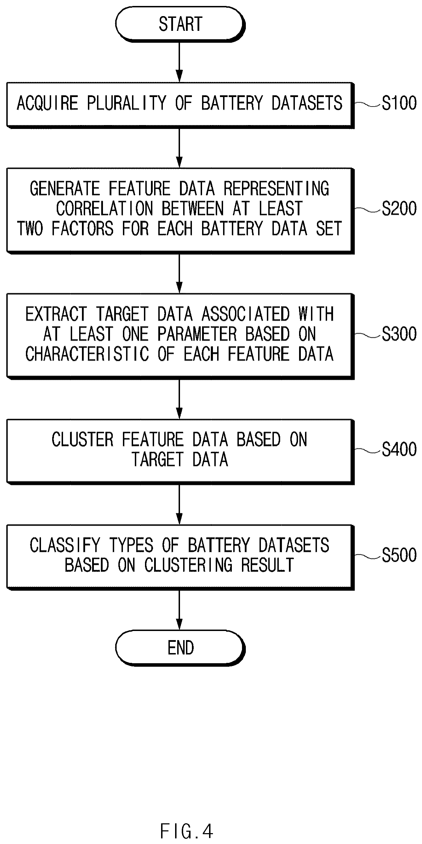

FIG. 4 is a flowchart illustrating an operation method of a data analysis apparatus according to an embodiment disclosed in this document. The embodiment shown in FIG. 4 is merely illustrative, and the order of operations according to various embodiments of the present invention may be different from that shown in FIG. 4, and some operations shown in FIG. 4 may be omitted, changed in order, or merged.

With reference to FIG. 4, the operating method of a battery analysis apparatus may include acquiring a plurality of battery datasets in operation S100, generating feature data representing the correlation between at least two factors for each battery dataset in operation S200, extracting target data associated with at least one factor based on the characteristics of the feature data for each feature data in operation S300, clustering the feature data based on the target data in operation S400, and classifying the types of battery datasets based on the clustering results in operation S500.

In operation S100, the information acquisition unit 110 may acquire a plurality of battery datasets. Each battery dataset may include time-series data for battery data. For example, the information acquisition unit 110 may receive battery data from battery management systems (BMS) of battery packs installed in each vehicle, as well as from on-board diagnostics (OBD) devices equipped in vehicles.

In operation S200, the controller 120 may generate feature data for each battery dataset. The controller 120 may generate feature data representing the correlation between at least two factors. In an embodiment, the controller 120 may generate feature data based on the joint probability density function of at least two factors.

In operation S300, the controller 120 may extract target data for each feature data. The controller 120 may also extract target data associated with at least one parameter based on the characteristics of the feature data. In an embodiment, the feature data may include contour image data, and the at least one parameter may include the number of peak points in the contour image, the width, length, and the coordinates of the center of each peak point.

In operation S400, the controller 120 may cluster the feature data based on the target data. The controller 120 may extract target data of smaller size from the feature data and perform clustering based on the target data, thereby producing clustering results with more distinct characteristics.

In operation S500, the controller 120 may classify the types of battery datasets based on the clustering results. The types of battery datasets may be represented by combinations of characters that can identify patterns of battery usage and driving habits of the users of vehicles equipped with the batteries.

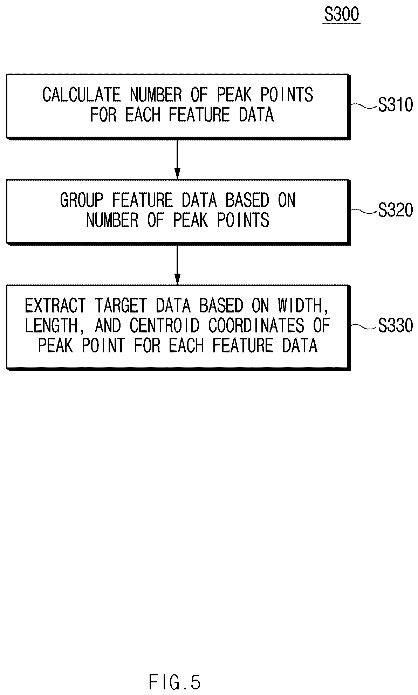

FIG. 5 is a flowchart illustrating the process of extracting target data by a data analysis apparatus according to an embodiment disclosed in this document.

With reference to FIG. 5, the extracting of the target data in operation S300 may include calculating the number of peak points for each feature data in operation S310, grouping feature data based on the number of peak points in operation S320, and extracting target data based on the width, length, and centroid coordinates of peak point for each feature data.

In operation S310, the controller 120 may calculate the number of peak points for each feature data. For example, the controller 120 may identify the highest point in a contour image (e.g., the point with the highest probability density) as a peak point. In another example, peak points may refer to the contours representing the highest data values (i.e., the highest contour lines).

In operation S320, the controller 120 may group feature data based on the number of peak points. The controller 120 may group feature data whose number of peak points is the same to cluster feature data using consistent criteria, as the size of the target data may vary depending on the number of peak points.

In operation S330, the controller 120 may extract target data based on the width, length, and centroid coordinates of each peak point for each feature data. For example, the controller 120 may extract the width, length, x-coordinate of the centroid, and y-coordinate of the centroid of each peak point for each feature data. In this case, the target data for each feature data may have a data size of (4 * the number of peak points).

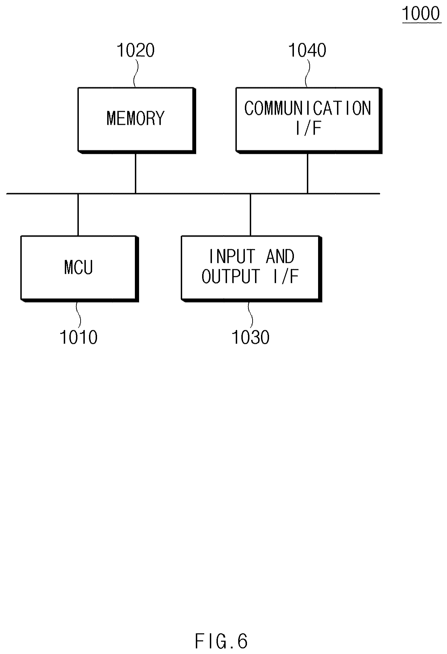

FIG. 6 is a diagram illustrating a hardware configuration of a computing system for performing the operating method of a data analysis apparatus according to an embodiment disclosed in this document.

With reference to FIG. 6, the computing system 1000 according to an embodiment disclosed in this document may include an MCU 1010, a memory 1020, an input and output I/F 1030, and a communication I/F 1040.

The MCU 1010 may be a processor that executes various programs (e.g., battery data acquisition programs, feature data generation programs, target data extraction programs, and type classification programs) stored in memory 1020 and processes various information, including time-series data of the dataset, through these programs to perform the functions of the controller included in the data analysis apparatus described with reference to FIG. 2.

The memory 1020 may store various programs such as battery data acquisition programs, feature data generation programs, target data extraction programs, and type classification programs. The memory 1020 may also store various information including clustering results and type classification results.

The 1020 may be provided in plurality, as necessary. The memory 1020 may be a volatile memory or a non-volatile memory. The memory 1020 as a volatile memory may be RAM, DRAM, SRAM, or the like. The memory 1020 as a non-volatile memory may be ROM, PROM, EAROM, EPROM, EEPROM, flash memory, or the like. The memory 1020 is not limited to listed examples and are not limited to these examples.

The input and output I/F 1030 is an interface that connects an input device (not shown) such as a keyboard, mouse, or touch panel, an output device such as a display (not shown), and the MCU 1010 to transmit and receive data.

The communication I/F 1040 may be a component capable of communicating various data with a server, encompassing various devices supporting wired or wireless communication. For example, the data analysis apparatus may transmit and receive various information to and from a separate external server via the communication interface 1040.

In this way, a computer program according to an embodiment disclosed in this document may be recorded in the memory 1020 and processed by the MCU 1010 to be implemented as modules performing the functions described with reference to FIG. 1.

Although all components are described as being combined or operating as one, the embodiments disclosed in this document are not limited to these examples. That is, within the scope of the embodiments disclosed in this document, all of the components may also be selectively combined in one or more ways to function.

Furthermore, terms such as "comprise," "include," or "have" as used above should be interpreted to imply the inclusion of the specified components unless specifically stated otherwise, rather than excluding other components, and may include additional components. Unless otherwise defined, all terms, including technical or scientific terms used herein, have the same meanings as commonly understood by those skilled in the art to which the embodiments disclosed in this invention belong. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

The above description is only an illustrative example of the technical idea disclosed in this document, and those skilled in the art to which the embodiments disclosed in this document belong will be able to make various modification and changes without departing from the subject matter of the embodiments disclosed in this document. Therefore, the embodiments disclosed in this document are not intended to limit the technical concept disclosed in this document but are for the purpose of illustration, and the scope of the technical concept disclosed in this document is not limited by these embodiments. The scope of protection for the technical concepts disclosed in this document should be interpreted in accordance with the claims set forth below, and all equivalent technical concepts should be considered as included in the scope of protection of this document.

## Claims

1. A data analysis apparatus comprising:
an information acquisition unit configured to acquire a plurality of battery datasets; and
a controller configured to generate, for each battery dataset, feature data representing correlation between at least two factors for analyzing the type of battery dataset, and
extract, for each feature data, target data associated with at least one parameter based on the characteristic of feature data, and cluster the feature data based on the target data.

2. The data analysis apparatus of claim 1, wherein the feature data comprises contour image data.

3. The data analysis apparatus of claim 2, wherein the at least one parameter comprises at least one of the number of peak points, the width, length, and centroid coordinates of each peak point in the contour image data.

4. The data analysis apparatus of claim 3, wherein the controller calculates the number of peak points for each feature data and group the feature data based on the number of peak points.

5. The data analysis apparatus of claim 4, wherein the controller extracts the target data based on the width, length, and centroid coordinates of the peak point for each feature data.

6. The data analysis apparatus of claim 4, wherein the controller clusters the feature data belonging to each group based on the target data.

7. The data analysis apparatus of claim 1, wherein the controller classifies the types of the battery datasets based on clustering result.

8. The data analysis apparatus of claim 1, wherein the controller generates the feature data based on the joint probability density function (Joint PDF) of the at least two factors.

9. An operating method of a data analysis apparatus, wherein the operating method of the data analysis apparatus comprising:
acquiring a plurality of battery datasets;
generating, for each battery dataset, feature data representing correlation between at least two factors for analyzing the type of battery dataset;
extracting, for each feature data, target data associated with at least one parameter based on the characteristic of feature data; and
clustering the feature data based on the target data.

10. The operating method of the data analysis apparatus of claim 9, wherein the feature data comprises contour image data, and the at least one parameter comprises at least one of the number of peak points, the width, length, and centroid coordinates of each peak point in the contour image data.

11. The operating method of the data analysis apparatus of claim 10, wherein the calculating of the target data comprises:
calculating the number of peak points for each feature data;
grouping the feature data based on the number of peak points; and
extracting the target data based on the width, length, and centroid coordinates of the peak point for each feature data.

12. The operating method of the data analysis apparatus of claim 11, wherein the clustering of the feature data based on the target data comprises:
for each group, clustering the feature data belonging to each group based on the target data.

13. The operating method of the data analysis apparatus of claim 9, further comprising classifying the types of the battery datasets based on clustering result.
